(19) Europäisches Patentamt
European Patent Office
Office européen des brevets

(11) EP 2 868 778 B1

(12) EUROPEAN PATENT SPECIFICATION

(45) Date of publication and mention of the grant of the patent:
**31.05.2023 Bulletin 2023/22**

(21) Application number: **14191883.9**

(22) Date of filing: **05.11.2014**

(51) International Patent Classification (IPC):
***H01L 23/00*** *(2006.01)* ***H05K 3/34*** *(2006.01)*
***C25D 3/32*** *(2006.01)* ***C25D 3/60*** *(2006.01)*
***C25D 7/12*** *(2006.01)*

(52) Cooperative Patent Classification (CPC):
(C-Sets available)
**C25D 3/32; C25D 3/60; C25D 7/123; H01L 24/11;**
H01L 24/05; H01L 24/13; H01L 24/94;
H01L 2224/05611; H01L 2224/05655;
H01L 2224/11462; H01L 2224/13082;
H01L 2224/13083; H01L 2224/131;
H01L 2224/13111; H01L 2224/13147; (Cont.)

# (54) METHOD FOR THE ELECTRODEPOSITION OF A TIN-CONTAINING LAYER

VERFAHREN ZUR ELEKTROLYTISCHEN ABSCHEIDUNG EINER ZINNHALTIGEN SCHICHT

MÉTHODE POUR L'ÉLECTRODÉPOSITION D'UNE COUCHE CONTENANT DE L'ÉTAIN

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(30) Priority: **05.11.2013 US 201314071679**

(43) Date of publication of application:
**06.05.2015 Bulletin 2015/19**

(73) Proprietor: **Rohm and Haas Electronic Materials LLC**
**Marlborough, MA 01752 (US)**

(72) Inventors:
- **Woertink, Julia**
  **Sudbury, Massachusetts 01776 (US)**
- **Qin, Yi**
  **Westborough, Massachusetts 01581 (US)**
- **Prange, Jonathan D.**
  **Lincoln, Massachusetts 01773 (US)**
- **Lopez Montesinos, Pedro O.**
  **Marlborough, MA 01752 (US)**

(74) Representative: **Houghton, Mark Phillip et al**
**Patent Outsourcing Limited**
**1 King Street**
**Bakewell, Derbyshire DE45 1DZ (GB)**

(56) References cited:
**EP-A2- 2 626 449**
**JP-A- S61 117 297**
**JP-A- 2001 342 592**
**JP-B2- 2 856 857**
**US-A- 4 072 582**
**US-A- 4 582 576**
**US-A1- 2011 189 848**

Note: Within nine months of the publication of the mention of the grant of the European patent in the European Patent Bulletin, any person may give notice to the European Patent Office of opposition to that patent, in accordance with the Implementing Regulations. Notice of opposition shall not be deemed to have been filed until the opposition fee has been paid. (Art. 99(1) European Patent Convention).

(52) Cooperative Patent Classification (CPC): (Cont.)
H01L 2224/13155; H01L 2224/94; H05K 3/3473

C-Sets
H01L 2224/05611, H01L 2924/00014;
H01L 2224/05655, H01L 2924/01026;
H01L 2224/11462, H01L 2924/00012;
H01L 2224/131, H01L 2924/014;
H01L 2224/13111, H01L 2924/00012;
H01L 2224/13111, H01L 2924/01025;
H01L 2224/13111, H01L 2924/01029;
H01L 2224/13111, H01L 2924/0103;
H01L 2224/13111, H01L 2924/01047;
H01L 2224/13111, H01L 2924/01047,
H01L 2924/01029;
H01L 2224/13111, H01L 2924/01047,
H01L 2924/01029, H01L 2924/01025;
H01L 2224/13111, H01L 2924/01047,
H01L 2924/01029, H01L 2924/01051;
H01L 2224/13111, H01L 2924/01047,
H01L 2924/0103, H01L 2924/01029;
H01L 2224/13111, H01L 2924/01047,
H01L 2924/01049;
H01L 2224/13111, H01L 2924/01047,
H01L 2924/01049, H01L 2924/01083;
H01L 2224/13111, H01L 2924/01047,
H01L 2924/01083;
H01L 2224/13111, H01L 2924/01049;
H01L 2224/13111, H01L 2924/01051;
H01L 2224/13111, H01L 2924/01079;
H01L 2224/13111, H01L 2924/01083;
H01L 2224/13111, H01L 2924/01322;
H01L 2224/13147, H01L 2924/00014;
H01L 2224/13155, H01L 2924/01026;
H01L 2224/94, H01L 2224/11

## Description

The present invention relates generally to the field of electrolytic metal plating. In particular, the present invention relates to the field of electrolytic tin plating.

Metals and metal-alloys are commercially important, particularly in the electronics industry where they are often used as electrical contacts, final finishes and solders. The use of tin-lead, once the most common tin-alloy solder, has declined due to the increasing restrictions on lead. Lead-free solders, such as tin, tin-silver, tin-copper, tin-bismuth, tin-silver-copper, and others, are common replacements for tin-lead solders. These solders are often deposited on a substrate using a plating bath, such as an electroplating bath.

Methods for electroplating articles with metal coatings generally involve passing a current between two electrodes in a plating solution where one of the electrodes (typically the cathode) is the article to be plated. A typical tin plating solution comprises dissolved tin ions, water, an acid electrolyte such as methanesulfonic acid in an amount sufficient to impart conductivity to the bath, an antioxidant, and proprietary additives to improve the uniformity of the plating and the quality of the metal deposit. Such additives include surfactants, and grain refiners, among others.

Certain applications for lead-free solder plating present challenges in the electronics industry. For example, when used as a capping layer on copper pillars, a relatively small amount of lead-free solder, such as tin-silver solder, is deposited on top of a copper pillar. In plating such small amounts of solder it is often difficult to plate a uniform height of solder composition on top of each pillar, both within a die and across the wafer. The use of conventional solder electroplating baths also results in deposits having a relatively rough surface morphology, for example, having a mean surface roughness (Ra) of about 800 nm or greater as measured by optical profilometry. Such relatively rough surface morphology often correlates with void formation in the solder after reflow, which ultimately creates concerns regarding solder joint reliability. Accordingly, there is interest in the industry for a tin or tin-alloy solder deposit which avoids the problem of a relatively rough surface morphology, and which provides improved within die uniformity.

Many conventional tin electroplating baths are known. When lustrous surfaces are desired, brighteners, sometimes referred to as grain refiners, are typically employed in the tin electroplating bath. Conventional brighteners include aldehydes, ketones, carboxylic acids, carboxylic acid derivatives, amines or mixtures thereof. It has been reported in U.S. Pat. No. 7,314,543 that tin layers deposited from an acidic tin electroplating bath containing a sulfopropylated anionic surfactant, such as those of the formula $R(OCH_2CH_2)_nO(CH_2)_3SO_3X$ where R is an n-alkyl and X is a cationic species, and a grain refiner such as between 10 and 30 ppm of benzylidene acetone do not show whiskers after 6 months of ambient storage. However, when tin or tin-alloy electroplating baths containing a sulfopropylated anionic surfactant and benzylidene acetone as a grain refiner are used to deposit tin-containing solder bumps on a semiconductor wafer, such solder bumps suffer from poor morphology and very poor within-die (WID) uniformity, generally > 30% WID. Accordingly, there remains a need in the industry for electroplating baths and methods for depositing a tin-containing solder layer, such as solder bump or a cap on a copper pillar, that has both acceptable morphology and good within-die uniformity.

JP-B2-2856857 discloses a tin, lead or tin-lead alloy plating bath wherein a surfactant, a brightener and lower unsaturated fatty acid amide is added to a plating bath containing. alkanesulfonic acid and the divalent tin salt and/or lead salt thereof. A plating film is obtained having superior suitability to reflowing, leveling and soldering. EP 2626449 A2 discloses a method for depositing a tin-silver layer wherein the plating bath comprises a water-soluble source of divalent tin ions, a water-soluble source of silver ions, water, acid electrolyte and an alkoxylated amine oxide surfactant, and wherein the substrate comprises copper pillars, such as those used in the manufacture of flip-chip interconnects.

The present invention provides a method of electroplating a tin-containing layer comprising:

providing a semiconductor wafer comprising a plurality of conductive bonding features, wherein the conductive bonding features are copper pillars;
contacting the semiconductor wafer with an electroplating composition comprising:

a source of tin ions; an acid electrolyte; 0.0001 to 0.045 g/L of a grain refiner of formula (1)

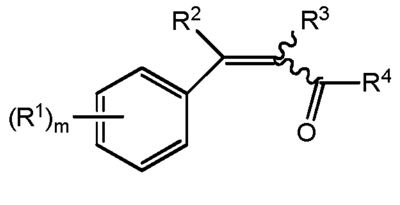
(1)

wherein each $R^1$ is independently $(C_{1-6})$alkyl, $(C_{1-6})$alkoxy, hydroxy, or halo; $R^2$ and $R^3$ are independently

chosen from H and ($C_{1-6}$)alkyl; $R^4$ is H, OH, ($C_{1-6}$)alkyl or O($C_{1-6}$)alkyl; m is an integer from 0 to 2; one or more nonionic surfactants of formula (3) or (4):

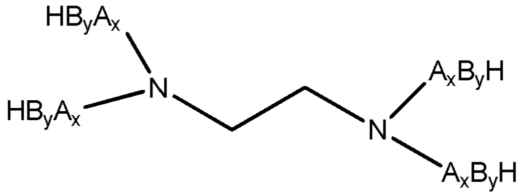

(3)

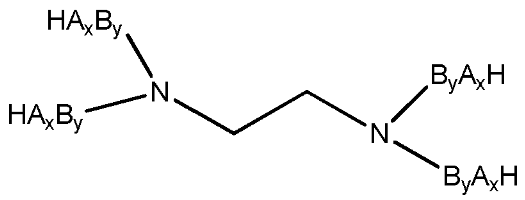

(4)

wherein A and B represent different alkyleneoxide moieties independently chosen from ($C_{2-4}$)alkyleneoxides, and x and y represent the number of repeat units of each alkyleneoxide, respectively; and water; and

applying sufficient current density to deposit a tin-containing layer on the conductive bonding features;

wherein the tin-containing layer on the conductive bonding features has a within-die uniformity of ≤ 5% and is substantially free of voids as plated and after reflow;

wherein the within-die uniformity is tested by patterned wafers having 75 µm diameter vias, 3 different pitch sizes which are 150, 225 and 375 µm, a platable area of 3-20%, a negative dry film resist height of 75 µm, and a seed of 1 kÅ Ti / 3 kÅ Cu, and measuring the height of 11 tin-containing bumps on each die using a stylus profilometer to obtain within-die uniformity calculated by equation 1 below in which within-die uniformity is expressed as "coplanarity":

$$Coplanarity(\%) = \frac{h_{max} - h_{min}}{2h_{avg}} \times 100 \quad (1)$$

where $h_{max}$ is the height of the highest tin-containing bump in a die, $h_{min}$ is the height of the shortest tin-containing bump in a die, and $h_{avg}$ is the average height of tin-containing solder bumps.

Figs. 1 is scanning electron micrograph (SEM) showing a tin-silver solder deposit using an electroplating bath for a method as disclosed herein.

Fig 2 is a SEM showing a tin-silver deposit using a comparative electroplating bath.

As used throughout this specification, the following abbreviations shall have the following meanings, unless the context clearly indicates otherwise: ASD = A/dm$^2$ = ampere per square decimeter; °C = degree Celsius; g = gram; mg = milligram; L = liter; Å = angstrom; nm = nanometer; µm = micron = micrometer; mm = millimeter; min = minute; DI = deionized; and mL = milliliter. All amounts are percent by weight ("wt%") and all ratios are weight ratios, unless otherwise noted. All numerical ranges are inclusive and combinable in any order, except where it is clear that such numerical ranges are constrained to add up to 100%.

As used throughout this specification, the term "plating" refers to metal electroplating. "Deposition" and "plating" are used interchangeably throughout this specification. "Pure tin" refers to a tin deposit that is not a tin-alloy, although such deposit may contain up to 5 atomic% of impurities. "Halide" refers to chloride, bromide, iodide and fluoride. The articles "a", "an" and "the" refer to the singular and the plural. "Alkyl" refers to linear, branched and cyclic alkyl. "Aryl" refers to aromatic carbocycles and aromatic heterocycles. The term "(meth)acrylic" refers to both "acrylic" and "methacrylic". When an element is referred to as being "disposed on" another element, it can be directly on the other element or intervening elements may be present therebetween. In contrast, when an element is referred to as being "disposed directly on" another element, there are no intervening elements present. As used herein, the term "and/or" includes any and all combinations of one or more of the associated listed items.

Compositions used in the method of the present invention comprise: a source of tin ions; an acid electrolyte; 0.0001 to 0.045 g/L of a grain refiner of formula (1)

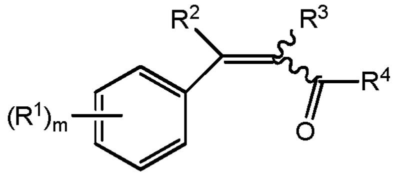

(1)

wherein each $R^1$ is independently $(C_{1-6})$alkyl, $(C_{1-6})$alkoxy, hydroxy, or halo; $R^2$ and $R^3$ are independently chosen from H and $(C_{1-6})$alkyl; $R^4$ is H, OH, $(C_{1-6})$alkyl or $O(C_{1-6})$alkyl; m is an integer from 0 to 2; one or more nonionic surfactants of formula (3) or (4):

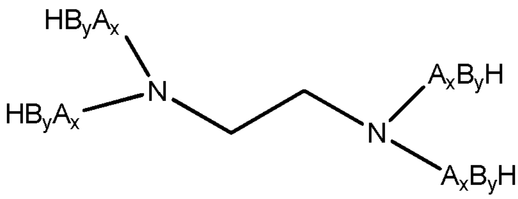

(3)

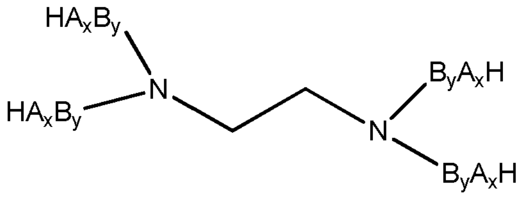

(4)

wherein A and B represent different alkyleneoxide moieties independently chosen from $(C_{2-4})$alkyleneoxides, and x and y represent the number of repeat units of each alkyleneoxide, respectively; and water.

Any bath-soluble divalent tin salt may suitably be used as the source of tin ions. Examples of such tin salts include, but are not limited to, tin oxide and salts such as tin halides, tin sulfates, tin alkane sulfonate such as tin methanesulfonate and tin ethanesulfonate, tin arylsulfonate such as tin phenylsulfonate, tin phenolsulfonate, tin cresolsulfonate, and tin toluenesulfonate, tin alkanolsulfonate, and the like. When tin halide is used, it is preferred that the halide is chloride. It is preferred that the tin compound is tin oxide, tin sulfate, tin chloride, tin alkane sulfonate or tin aryl sulfonate. More preferably, the tin salt is the stannous salt of methanesulfonic acid, ethanesulfonic acid, propanesulfonic acid, 2-hydroxyethane-1-sulfonic acid, 2-hydroxypropane-1-sulfonic acid, 1-hydroxypropane-2-sulfonic acid, phenylsulfonic acid, toluenesulfonic acid, phenolsulfonic acid, or cresolsulfonic acid, and even more preferably methanesulfonic acid, phenylsulfonic acid or phenolsulfonic acid. Mixtures of tin salts may be used. The tin compounds useful in the present invention are generally commercially available from a variety of sources and may be used without further purification. Alternatively, the tin compounds useful in the present invention may be prepared by methods known in the literature. Typically, the amount of tin ions in the present composition is in the range of 10 to 300 g/L, preferably from 20 to 200 g/L, and more preferably from 30 to 100 g/L.

Any acid electrolyte that is bath-soluble and does not otherwise adversely affect the electrolyte composition may be used in the present invention. Suitable acid electrolytes include, but are not limited to: alkanesulfonic acids such as methanesulfonic acid, ethanesulfonic acid and propanesulfonic acid; arylsulfonic acids such as phenylsulfonic acid, toluenesulfonic acid, phenolsulfonic acid, and cresolsulfonic acid; alkanolsulfonic acids; sulfuric acid; sulfamic acid; and mineral acids such as hydrochloric acid, hydrobromic acid and fluoroboric acid. Alkanesulfonic acids and arylsulfonic acids are preferred acid electrolytes, and alkanesulfonic acids are more preferred. Methanesulfonic acid is particularly preferred. Mixtures of acid electrolytes are particularly useful, such as, but not limited to, mixtures of alkane sulfonic acids and sulfuric acid. Thus, more than one acid electrolyte may be used advantageously in the present invention. The acidic electrolytes useful in the present invention are generally commercially available and may be used without further purification. Alternatively, the acid electrolytes may be prepared by methods known in the literature. Typically, the amount of acid in the present compositions is in the range of 10 to 1000 g/L, preferably from 20 to 750 g/L, and more preferably from 30 to 500 g/L.

The compositions comprise a grain refiner chosen from a compound of formula (1)

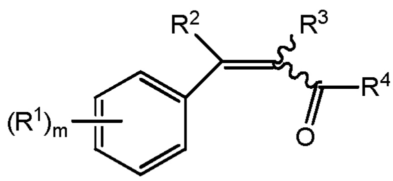

(1)

wherein each $R^1$ is independently $(C_1\text{-}_6)$alkyl, $(C_1\text{-}_6)$alkoxy, hydroxy, or halo; $R^2$ and $R^3$ are independently chosen from Hand $(C_1\text{-}_6)$alkyl; $R^4$ is H, OH, $(C_1\text{-}_6)$alkyl or $O(C_1\text{-}_6)$alkyl; and m is an integer from 0 to 2. Preferably, each $R^1$ is independently $(C_1\text{-}_6)$alkyl, $(C_1\text{-}_3)$alkoxy, or hydroxy, and more preferably $(C_1\text{-}_4)$alkyl, $(C_1\text{-}_2)$alkoxy, or hydroxy. It is preferred that $R^2$ and $R^3$ are independently chosen from Hand $(C_1\text{-}_3)$alkyl, and more preferably H and methyl. Preferably, $R^4$ is H, OH, $(C_1\text{-}_4)$alkyl or $O(C_1\text{-}_4)$alkyl, and more preferably H, OH, or $(C_1\text{-}_4)$alkyl. It is preferred that m is 0 or 1, and more preferably m is 0. A mixture of grain refiners may be used, such as 2 different grain refiners of formula 1.

Exemplary compounds useful as the grain refiner include, but are not limited to, cinnamic acid, cinnamaldehyde, benzylidene acetone, or mixtures thereof.

The grain refiner is present in the plating baths in an amount of 0.0001 to 0.045 g/L. Preferably, the grain refiner is present in an amount of 0.0001 to 0.04 g/L, more preferably in an amount of 0.0001 to 0.035 g/L, and yet more preferably from 0.0001 to 0.03 g/L. Compounds useful as the grain refiners are generally commercially available from a variety of sources and may be used as is or may be further purified.

One or more nonionic surfactants that are tetrafunctional polyethers derived from the addition of different alkylene oxides to ethylenediamine compounds are used in the present compositions. Such surfactants have the formula (3) or (4):

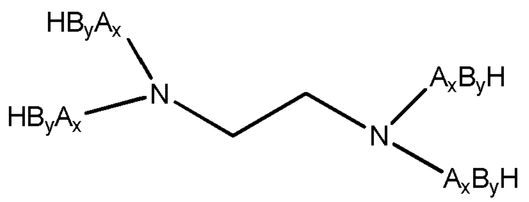

(3)

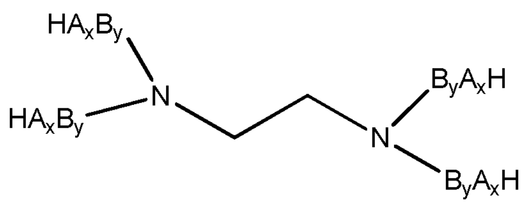

(4)

wherein A and B represent different alkyleneoxide moieties, and x and y represent the number of repeat units of each alkyleneoxide, respectively. A and B are chosen from $(C_{2\text{-}4})$alkyleneoxides, and more preferably from propyleneoxide (PO) and ethyleneoxide (EO). The alkyleneoxy moieties in the compounds of formulae 3 and 4 may be in block, alternating or random arrangements, and preferably are in a block arrangement. The mole ratio of x:y in formulae 3 and 4 is typically from 10:90 to 90:10, and preferably from 10:90 to 80:20. These nonionic surfactants typically have an average molecular weight of 500 to 40000, and preferably from 750 to 35000, and more preferably from 1000 to 30000. Such tetrafunctional polyethers are generally commercially available, such as from BASF (Ludwigshafen, Germany) under the TETRONIC brand, and may be used as-is without further purification. These nonionic surfactants are typically present in the electrolyte compositions in a concentration of from 1 to 10,000 ppm, based on the weight of the composition, and preferably from 5 to 10,000 ppm.

In general, the present compositions contain water. The water may be present in a wide range of amounts. Any type of water may be used, such as distilled, DI or tap.

The present compositions may optionally include one or more additives, such as antioxidants, organic solvents, alloying metals, conductivity acids, secondary grain refiners, secondary surfactants, complexers, and mixtures thereof.

Antioxidants may optionally be added to the present composition to assist in keeping the tin in a soluble, divalent state. It is preferred that one or more antioxidants are used in the present compositions. Exemplary antioxidants include, but are not limited to, hydroquinone, and hydroxylated aromatic compounds, including sulfonic acid derivatives of such aromatic compounds, and preferably are: hydroquinone; methylhydroquinone; resorcinol; catechol; 1,2,3-trihydroxybenzene; 1,2-dihydroxybenzene-4-sulfonic acid; 1,2-dihydroxybenzene-3,5-disulfonic acid; 1,4- dihydroxybenzene-2-sulfonic acid; 1,4-dihydroxybenzene-2,5-disulfonic acid; and 2,4-dihyroxybenzene sulfonic acid. Such antioxidants are disclosed in U.S. Pat. No. 4,871,429. Other suitable antioxidants or reducing agents include, but are not limited to, vanadium compounds, such as vanadylacetylacetonate, vanadium triacetylacetonate, vanadium halides, vanadium oxyhalides, vanadium alkoxides and vanadyl alkoxides. The concentraion of such reducing agent is well known to those skilled in the art, but is typically in the range of from 0.1 to 10 g/L, and preferably from 1 to 5 g/L. Such antioxidants are generally commercially available from a variety of sources.

Optional organic solvents may be added to the present tin electroplating composition. Typical solvents useful in the present compositions are aliphatic alcohols. Preferred organic solvents are methanol, ethanol, n-propanol, isoproponol, n-butanol, and iso-butanol. Such solvent may be used in the present tin electroplating compositions in an amount if from 0.05 to 15 g/L, and preferably from 0.05 to 10 g/L.

Optionally, the present plating baths may contain one or more sources of alloying metal ions. Suitable alloying metals include, without limitation, silver, gold, copper, bismuth, indium, zinc, antimony, manganese and mixtures thereof. Preferred alloying metals are silver, copper, bismuth, indium, and mixtures thereof, and more preferably silver. It is

preferred that the present compositions are free of lead. Any bath-soluble salt of the alloying metal may suitably be used as the source of alloying metal ions. Examples of such alloying metal salts include, but are not limited to: metal oxides; metal halides; metal fluoroborate; metal sulfates; metal alkanesulfonates such as metal methanesulfonate, metal ethanesulfonate and metal propanesulfonate; metal arylsulfonates such as metal phenylsulfonate, metal toluenesulfonate, and metal phenolsulfonate; metal carboxylates such as metal gluconate and metal acetate; and the like. Preferred alloying metal salts are metal sulfates; metal alkanesulfonates; and metal arylsulfonates. When one alloying metal is added to the present compositions, a binary alloy deposit is achieved. When 2, 3 or more different alloying metals are added to the present compositions, tertiary, quaternary or higher order alloy deposits are achieved. The amount of such alloying metal used in the present compositions will depend upon the particular tin-alloy desired. The selection of such amounts of alloying metals is within the ability of those skilled in the art. It will be appreciated by those skilled in the art that when certain alloying metals, such as silver, are used, an additional complexing agent may be required. Such complexing agents (or complexers) are well-known in the art and may be used in any suitable amount.

Conductivity acids may optionally be added to the present compositions. Such conductivity acids include, but are not limited to, boric acid, alkanoic acids, hydroxyalkanoic acids, and salts of these acids to the extent they are water-soluble. Preferred are formic acid, acetic acid, oxalic acid, citric acid, malic acid, tartaric acid, gluconic acid, glucaric acid, glucuronic acid, and salts of these acids. When used, such conductivity acids and their salts are employed in conventional amounts.

In addition to the grain refiner described above, the present compositions may optionally include one or more secondary grain refiners. A wide variety of such secondary grain refiners are known in the art and any are suitable, such as those described in U.S. Pat. No. 4,582,576. Preferred secondary grain refiners useful in the present compositions are $\alpha,\beta$-unsaturated aliphatic carbonyl compounds including, but are not limited to, $\alpha,\beta$-unsaturated carboxylic acids, $\alpha,\beta$-unsaturated carboxylic acid esters, $\alpha,\beta$-unsaturated amides, and $\alpha,\beta$-unsaturated aldehydes. Preferably, the secondary grain refiner is chosen from $\alpha,\beta$-unsaturated carboxylic acids, $\alpha,\beta$-unsaturated carboxylic acid esters, and $\alpha,\beta$-unsaturated aldehydes, and more preferably $\alpha,\beta$-unsaturated carboxylic acids, and $\alpha,\beta$-unsaturated aldehydes. Exemplary secondary grain refiners include (meth)acrylic acid, crotonic acid, $(C_{1-6})$alkyl (meth)acrylate, (meth)acrylamide, $(C_1\text{-}C_6)$alkyl crotonate, crotonamide, crotonaldehyde, (meth)acrylaldehyde, or mixtures thereof. Preferred $\alpha,\beta$-unsaturated aliphatic carbonyl compounds are (meth)acrylic acid, crotonic acid, crotonaldehyde, (meth)acrylaldehyde or mixtures thereof. When present, the secondary grain refiner is typically used in an amount of 0.005 to 5 g/L. Preferably, the secondary grain refiner is present in an amount of 0.005 to 0.5 g/L, more preferably in an amount of 0.005 to 0.25 g/L, and yet more preferably from 0.01 to 0.25 g/L. Compounds useful as the secondary grain refiners are generally commercially available from a variety of sources and may be used as is or may be further purified.

Optionally, one or more secondary surfactants may be used in the preset compositions. Such secondary surfactants may be anionic, nonionic, amphoteric or cationic, and preferably are nonionic. Such secondary surfactants typically have an average molecular weight of from 200 to 100,000, preferably from 500 to 50,000, more preferably from 500 to 25,000, and yet more preferably from 750 to 15,000. When used in the present compositions, such secondary surfactants are typically present in a concentration of from 1 to 10,000 ppm, based on the weight of the composition, and preferably from 5 to 10,000 ppm. Preferred nonionic surfactants are alkyleneoxide containing surfactants, particularly polyalkylene glycols, and $(C_{2-4})$alkyleneoxide condensation products, either of which may be capped with an organic compound having at least one hydroxy group and 20 carbon atoms or less with one type of alkyleneoxide or with 2 or more different alkyleneoxides. Preferred alkyleneoxides are ethyleneoxide, propyleneoxide, butyleneoxide and mixtures thereof.

Typically, the polyalkylene glycols useful as secondary surfactants are those having an average molecular weight in the range of 200 to 100,000, and preferably from 900 to 20,000. Preferred polyalkylene glycols are polyethylene glycol, and polypropylene glycol. Such polyalkylene glycols are generally commercially available from a variety of sources and may be used without further purification. Capped polyalkylene glycols where one or more of the terminal hydrogens are replaced with a hydrocarbyl group may also be suitably used. Examples of suitable polyalkylene glycols are those of the formula $R\text{-}O\text{-}(CXYCX'Y'O)_nR'$ where R and R' are independently chosen from H, $(C_{2-20})$alkyl group and $C_{6-20}$aryl group; each of X, Y, X' and Y' is independently selected from hydrogen, alkyl such as methyl, ethyl or propyl, aryl such as phenyl, or aralkyl such as benzyl; and n is an integer from 5 to 100,000. Typically, one or more of X, Y, X' and Y' is hydrogen.

Particularly useful $(C_{2-4})$alkyleneoxide condensation products are ethyleneoxide/propyleneoxide ("EO/PO") copolymers. Suitable EO/PO copolymers generally have a weight ratio of EO:PO of from 10:90 to 90:10, and preferably 10:90 to 80:20. Such EO/PO copolymers preferably have an average molecular weight of from 1000 to 15,000. Preferred EO/PO copolymers are block copolymers having the structure of EO/PO/EO or PO/EO/PO. Such EO/PO copolymers are available from a variety of sources, such as those available from BASF under the PLURONIC brand. Suitable alkyleneoxide condensation products capped with an organic compound having at least one hydroxy group and 20 carbon atoms or less include those having an aliphatic hydrocarbon of from one to seven carbon atoms, an unsubstituted aromatic compound or an alkylated aromatic compound having six carbons or less in the alkyl moiety, such as those

disclosed in U.S. Pat. No. 5,174,887. The aliphatic alcohols may be saturated or unsaturated. Suitable aromatic compounds are those having up to two aromatic rings. The aromatic alcohols have up to 20 carbon atoms prior to derivatization with ethyleneoxide. Such aliphatic and aromatic alcohols may be further substituted, such as with sulfate or sulfonate groups. Such suitable alkylene oxide compounds include, but are not limited to: ethoxylated polystyrenated phenol having 12 moles of EO, ethoxylated butanol having 5 moles of EO, ethoxylated butanol having 16 moles of EO, ethoxylated butanol having 8 moles of EO, ethoxylated octanol having 12 moles of EO, ethoxylated beta-naphthol having 13 moles of EO, ethoxylated bisphenol A having 10 moles of EO, ethoxylated sulfated bisphenol A having 30 moles of EO and ethoxylated bisphenol A having 8 moles of EO.

The electroplating compositions may be prepared by any suitable method known in the art. Typically, they are prepared by adding the acid electrolyte to a vessel, followed by tin compounds, grain refiners, surfactants, water and any other optional components. Other orders of addition of the components of the compositions may be used. Once the composition is prepared, any undesired material is removed, such as by filtration, and then water is added to adjust the final volume of the composition. The composition may be agitated by any known means, such as stirring, pumping, sparging or jetting the composition, for increased deposition speed.

Plating baths for use in the method of the invention are acidic, that is, they have a pH of $< 7$. Typically, the pH of the present plating baths is from -1 to $< 7$, preferably from -1 to 6.5, more preferably from -1 to 6, and yet more preferably from -1 to 2.

The present electroplating compositions are suitable for depositing a tin-containing layer which may be a pure tin layer or a tin-alloy layer. Exemplary tin-alloy layers include, without limitation, tin-silver, tin-silver-copper, tin-silver-copper-antimony, tin-silver-copper-manganese, tin-silver-bismuth, tin-silver-indium, tin-silver-zinc-copper, and tin-silver-indium-bismuth. Preferably, the present electroplating compositions deposit pure tin, tin-silver, tin-silver-copper, tin-silver-bismuth, tin-silver-indium, and tin-silver-indium-bismuth, and more preferably pure tin, tin-silver or tin-silver-copper. Alloys deposited from the present electroplating bath contain an amount of tin ranging from 0.01 to 99.99 wt%, and an amount of one or more alloying metals ranging from 99.99 to 0.01 wt%, based on the weight of the alloy, as measured by either atomic adsorption spectroscopy (AAS), X-ray fluorescence (XRF), inductively coupled plasma (ICP) or differential scanning calorimetry (DSC). Preferably, the tin-silver alloys deposited using the present invention contain from 75 to 99.99 wt % tin and 0.01 to 10 wt % of silver and any other alloying metal. More preferably, the tin-silver alloy deposits contain from 95 to 99.9 wt % tin and 0.1 to 5 wt % of silver and any other alloying metal. Tin-silver alloy is the preferred tin-alloy deposit, and preferably contains from 90 to 99.9 wt% tin and from 10 to 0.1 wt% silver. More preferably, the tin-silver alloy deposits contain from 95 to 99.9 wt% tin and from 5 to 0.1 wt% silver. For many applications, the eutectic composition of an alloy may be used. Alloys deposited according to the present invention are substantially free of lead, that is, they contain $\leq 1$ wt% lead, more preferably $\leq 0.5$ wt%, and yet more preferably $\leq 0.2$ wt%, and still more preferably are free of lead.

The plating compositions are useful in various plating methods where a tin-containing layer is desired, and particularly for depositing a tin-containing solder layer on a semiconductor wafer comprising a plurality of conductive bonding features. Plating methods include, but are not limited to, horizontal or vertical wafer plating, barrel plating, rack plating, high speed plating such as reel-to-reel and jet plating, and rackless plating, and preferably horizontal or vertical wafer plating. The substrates which are plated with a tin-containing deposit using a method according to the present invention are semiconductor wafers. The bonding features comprise copper pillars. Optionally, the copper pillars may comprise a top metal layer, such as a nickel layer. When the conductive bonding features have a top metal layer, then the pure tin solder layer is deposited on the top metal layer of the bonding feature. Conductive bonding features, such as bonding pads, copper pillars, and the like, are well-known in the art, such as described in U.S. Pat. No. 7,781,325, and in U.S. Pat. Pub. Nos. 2008/0054459, 2008/0296761, and 2006/0094226.

As used herein, the term "semiconductor wafer" is intended to encompass "an electronic device substrate," "a semiconductor substrate," "a semiconductor device," and various packages for various levels of interconnection, including a single-chip wafer, multiple-chip wafer, packages for various levels, or other assemblies requiring solder connections. Particularly suitable substrates are patterned wafers, such as patterned silicon wafers, patterned sapphire wafers and patterned gallium-arsenide wafers. Such wafers may be any suitable size. Preferred wafer diameters are 200 mm to 300 mm, although wafers having smaller and larger diameters may be suitably employed according to the present invention. As used herein, the term "semiconductive substrates" includes any substrate having one or more semiconductor layers or structures which include active or operable portions of semiconductor devices. The term "semiconductor substrate" is defined to mean any construction comprising semiconductive material, including but not limited to bulk semiconductive material such as a semiconductive wafer, either alone or in assemblies comprising other materials thereon, and semiconductive material layers, either alone or in assemblies comprising other materials. A semiconductor device refers to a semiconductor substrate upon which at least one microelectronic device has been or is being batch fabricated.

A substrate is plated with a tin-containing layer by contacting the substrate with the present compositions and applying a current density for a period of time to deposit the tin-containing layer on the substrate. Such contact is may be by placing the substrate to be plated in the plating bath composition, or pumping the plating bath composition onto

the substrate. The substrate is conductive and is the cathode. The plating bath contains an anode, which may be soluble or insoluble. Potential is typically applied to the cathode. Sufficient current density is applied and plating performed for a period of time sufficient to deposit a tin-containing layer having a desired thickness on the substrate. Semiconductor wafers comprising a plurality of bonding features are electroplated by contacting the wafer with a plating bath as described herein and applying a current density for a period of time to deposit a tin-containing layer on the plurality of bonding features. The semiconductor wafer functions as the cathode.

The particular current density used to deposit the tin-containing layer depends on the particular plating method, the substrate to be plated, and whether a pure tin or tin-alloy layer is to be deposited. Suitable current density is from 0.1 to 200 A/dm$^2$. Preferably the current density is from 0.5 to 100 A/dm$^2$, more preferably from 0.5 to 30 A/dm$^2$, even more preferably from 0.5 to 20 A/dm$^2$, and most preferably from 2 to 20 A/dm$^2$. Other current densities may be useful depending upon the particular bonding feature to be plated, as well as other considerations known to those skilled in the art. Such current density choice is within the abilities of those skilled in the art.

Tin-containing layers may be deposited at a temperature of 10° C or higher, preferably in the range of from 10 to 65° C, and more preferably from 15 to 40° C. In general, the longer the time the substrate is plated the thicker the deposit while the shorter the time the thinner the deposit for a given temperature and current density. Thus, the length of time a substrate remains in a plating composition may be used to control the thickness of the resulting tin-containing deposit. In general, metal deposition rates may be as high as 15 $\mu$m/min. Typically, deposition rates may range from 0.5 to 15 $\mu$m/min and preferably from 1 to 10 $\mu$m/min.

While the present electrolyte compositions may be used for a variety of applications as described above, an exemplary application is for interconnect bump (solder bump) formation for wafer-level-packaging. This method involves providing a semiconductor die (wafer die) having a plurality of conductive bonding features (such as interconnect bump pads), forming a seed layer over the bonding features, depositing a tin-containing interconnect bump layer over the bonding features by contacting the semiconductor die with the present electroplating composition and passing a current through the electroplating composition to deposit the tin-containing interconnect bump layer on the substrate, and then reflowing the interconnect bump layer to form a solder bump. The conductive interconnect bump pad may be one or more layers of a metal, composite metal or metal alloy typically formed by physical vapor deposition (PVD) such as sputtering. Typical conductive bonding features comprise, without limitation, aluminum, copper, titanium nitride, and alloys thereof.

A passivation layer is formed over the bonding features and openings extending to the bonding features are formed therein by an etching process, typically by dry etching. The passivation layer is typically an insulating material, for example, silicon nitride, silicon oxynitride, or a silicon oxide, such as phosphosilicate glass. Such materials may be deposited by chemical vapor deposition (CVD) processes, such as plasma enhanced CVD. An under bump metallization (UBM) structure formed typically of a plurality of metal or metal alloy layers, is deposited over the device. The UBM acts as an adhesive layer and electrical contact base (seed layer) for an interconnect bump to be formed. The layers forming the UBM structure may be deposited by PVD, such as sputtering or evaporation, or CVD processes. Without limitations, the UBM structure may be, for example, a composite structure including in order, a bottom chrome layer, a copper layer, and an upper tin layer. Nickel is one metal used in UBM applications.

In general, a photoresist layer is applied to a semiconductor wafer, followed by standard photolithographic exposure and development techniques to form a patterned photoresist layer (or plating mask) having openings or vias therein (plating vias). The dimensions of the plating mask (thickness of the plating mask and the size of the openings in the pattern) defines the size and location of the tin-silver layer deposited over the I/O pad and UBM. The diameters of such deposits typically range from 5 to 300 $\mu$m, preferably from 10 to 150 $\mu$m. The height of such deposits typically range from 10 to 150 $\mu$m, preferably from 15 to 150 $\mu$m, and more preferably from 20 to 80 $\mu$m. Suitable photoresist materials are commercially available (such as from Dow Electronic Materials, Marlborough, Massachusetts, USA) and are well-known in the art.

The interconnect bump material is deposited on the device by an electroplating process using the above-described electroplating compositions. Interconnect bump materials include, for example, pure tin or any suitable tin-alloys. Exemplary tin-alloys are those described above. It may be desired to use such alloys at their eutectic compositions, or at any other suitable compositions. The bump material is electrodeposited in the areas defined by the plating via. For this purpose, a horizontal or vertical wafer plating system, for example, a fountain plating system, is typically used with a direct current or pulse-plating technique. In the plating process, the interconnect bump material completely fills the via extending above and on a portion of the top surface of the plating mask, resulting in a mushroom-shaped metal deposit. This ensures that a sufficient volume of interconnect bump material is deposited to achieve the desired ball size after reflow. In the via plating process, the photoresist has a sufficient thickness such that the appropriate volume of interconnect bump material is contained within the plating mask via. A layer of copper or nickel may be electrodeposited in the plating via prior to plating the interconnect bump material. Such a layer may act as a wettable foundation to the interconnect bump upon reflow.

Following deposition of the interconnect bump material the plating mask is stripped using an appropriate solvent

or other remover. Such removers are well known in the art. The UBM structure is then selectively etched using known techniques, removing all metal from the field area around and between interconnect bumps.

Alternatively, after plating vias are formed in the photoresist layer, a metal interconnect structure, such as a pillar, that is free of tin, may be deposited on the bonding features. Copper pillars are conventional. Typically, such metal deposition will stop before the plating via is completely filled. Such interconnect structures, such as copper pillars, may then be capped by a tin-containing layer by an electroplating process using the above-described electroplating compositions. The tin-containing layer is electrodeposited in the areas defined by the plating via. For this purpose, a horizontal or vertical wafer plating system, for example, a fountain plating system, is typically used with a direct current or pulse-plating technique. A layer of a top metal, such as nickel, may be electrodeposited in the plating via on top of the copper pillar prior to plating the tin-containing layer. Such a top metal layer may act as a wettable foundation to pure tin solder layer, and/or provide a barrier layer. The height of such tin-containing layer may range from 20 to 50 μm although other heights may be suitable, and has a diameter substantially equal to that of the interconnect structure on which it is deposited. Following deposition of the tin-containing solder layer, the plating mask is stripped using an appropriate solvent or other remover. Such removers are well known in the art. The UBM structure is then selectively etched using known techniques, removing all metal from the field area around and between interconnect bumps.

The wafer is then optionally fluxed and is heated in a reflow oven to a temperature at which the tin-containing solder layer melts and flows into a truncated substantially spherical shape. Heating techniques are known in the art, and include, for example, infrared, conduction, and convection techniques, and combinations thereof. The reflowed interconnect bump is generally coextensive with the edges of the UBM structure. The heat treatment step may be conducted in an inert gas atmosphere or in air, with the particular process temperature and time being dependent upon the particular composition of the interconnect bump material.

Tin-containing solders electrodeposited from the present compositions are substantially free of voids when deposited (or plated), preferably these solders are substantially free of voids after one reflow cycle and preferably after repeated reflow cycles, such as after 3 reflow cycles, and more preferably after 5 reflow cycles. A suitable reflow cycle uses a Falcon 8500 tool from Sikama International, Inc., having 5 heating and 2 cooling zones, using temperatures of 140/190/230/230/260° C, with a 30 second dwell time, and a conveyor rate of ca. 100 cm/min. and a nitrogen flow rate of 40 cubic feet/hour. Alpha 100-40 flux (Cookson Electronics, Jersey City, New Jersey, USA) is a suitable flux used in this reflow process. As used herein, the term "voids" refers to both interfacial voids and voids within the bulk tin-containing layer. By "substantially free of voids" is meant that no void of a diameter larger than 3 μm, preferably 2 μm, and more preferably 1 μm, is visible using a Cougar microfocus X-ray system (YXLON International GmbH, Hamburg, Germany).

Uniformity of solder bumps is critical to ensuring proper attachment of components to the wafer. Within-die (WID) uniformity is a used to determine of the uniformity of the average heights of the tin-containing deposit within a given die. Within-wafer (WIW) uniformity is used to determine the uniformity of the average heights of the tin-containing deposit across a semiconductor wafer. Tin-containing solders deposited on semiconductor wafers using the present compositions have very good WID and WIW uniformity, as tested by patterned wafers having 75 μm diameter vias, 3 different pitch sizes (150, 225 and 375 μm), a platable area of 3-20%, a negative dry film resist height of 75 μm, and a seed of 1 kÅ Ti / 3 kÅ Cu. The height of 11 bumps was measured on each die using a stylus profilometer (KLA-Tencor P-15 Surface Profiler, Milpitas, California, USA) to obtain WID uniformity (or coplanarity) which was calculated by equation 1:

$$Coplanarity(\%) = \frac{h_{max} - h_{min}}{2h_{avg}} \times 100 \qquad (1)$$

where $h_{max}$ is the height of the highest tin-containing bump in a die, $h_{min}$ is the height of the shortest tin-containing bump in a die, and $h_{avg}$ is the average height of tin-containing solder bumps. The smaller the coplanarity value (or WID uniformity), the more uniform the tin-containing solder bumps. The present electroplating compositions have very good WID uniformity that is a WID uniformity of ≤ 5%, and preferably ≤ 3%. Such solder deposits also show very good WIW uniformity, that is a WIW uniformity of ≤ 5%, preferably ≤ 4.5%, and even more preferably ≤ 4%. The present electroplating compositions also provide tin-containing solder deposits having a relatively smooth surface as plated, that is, the surface as plated has a mean surface roughness ($R_a$) of ≤ 200 nm, preferably ≤ 150 nm and even more preferably ≤ 100 nm, as measured using an optical profilometer (Leica DCM3D, Leica Microsystems GmbH, Wetzlar, Germany).

Example 1 (not according to the invention):

An electroplating composition for depositing a tin-silver alloy was prepared by combining 75 g/L tin (from tin methanesulfonate), 0.65 g/L silver (from silver methanesulfonate), 104 g/L methanesulfuonic acid, 5 g/L of a tetrafunctional block copolymer derived from the sequential addition of EO and PO to ethylenediamine nonionic surfactant (EO:PO of approximately 40:60, TETRONIC 90R4), 0.0166 g/L of benzylidene acetone as the first grain refiner, 0.1 g/L of methacrylic acid as the second grain refiner, 0.6 g/L of a dithiaalkyldiol as a first silver complexing agent, 3.1 g/L of a mercaptotetrazole derivative as a second silver complexing agent, 1.5 g/L of alcohol solvent, 1 g/L of a commercial antioxidant, and DI water (balance). The pH of the composition was < 1.

Wafer segments of 4 cm x 4 cm with photoresist patterned vias of 75 μm (diameter) x 75 μm (depth) and a copper seed layer were immersed in the above electroplating composition and plated with tin-silver bumps using a current density of 8 $A/dm^2$. The temperature of the bath was at 25° C. An insoluble platinized titanium electrode was used as the anode. Electroplating was done until a bump of 60 μm was plated. Fig. 1 is a SEM of a tin-silver solder bump as plated. As can be seen from Fig. 1, the resulting tin-silver solder bump deposit was flat and had a smooth morphology. The plated wafer segments were found to have a very good WID uniformity of 5% as plated, with a mean surface roughness of 250 nm as measured using a Leica DCM3D optical profilometer. The tin-silver solder deposits were then reflowed one time using a Falcon 8500 tool (Sikama International, Inc.) having 5 heating and 2 cooling zones, using temperatures of 140/190/230/230/260° C, with a 30 second dwell time, and a conveyor rate of ca. 100 cm/min. and a nitrogen flow rate of 19 L/min (40 cubic feet/hour). The solder deposits were fluxed with Alpha 100-40 flux. The reflowed tin-silver deposits were evaluated using a Cougar microfocus X-ray system (YXLON International GmbH, Hamburg, Germany) and were found to be free of voids.

Example 2 (not according to the invention):

An electroplating composition for depositing a tin-silver alloy was prepared by combining 75 g/L tin (from tin methanesulfonate), 0.65 g/L silver (from silver methanesulfonate), 104 g/L methanesulfuonic acid, 5 g/L of a tetrafunctional block copolymer derived from the sequential addition of EO and PO to ethylenediamine nonionic surfactant (EO:PO of approximately 40:60, TETRONIC 90R4), 0.0166 g/L of benzylidene acetone as the grain refiner, 0.6 g/L of a dithiaalkyldiol as a first silver complexing agent, 3.1 g/L of a mercaptotetrazole derivative as a second silver complexing agent, 1.5 g/L of alcohol solvent, 1 g/L of a commercial antioxidant, and DI water (balance). The pH of the composition was < 1. Wafer segments (4 cm x 4 cm) with photoresist patterned vias of 75 μm (diameter) x 75 μm (depth) and a copper seed layer were immersed in the electroplating composition and plated with tin-silver bumps according to the procedure of Example 1. The resulting tin-silver solder bump deposit showed similar WID uniformity and morphology, and the bumps were found to be void-free after reflow.

Example 3: An electroplating composition for depositing pure tin was prepared by combining 75 g/L tin (from tin methanesulfonate), 104 g/L methanesulfuonic acid, 5 g/L of a tetrafunctional block copolymer derived from the sequential addition of EO and PO to ethylenediamine nonionic surfactant (EO:PO of approximately 40:60, TETRONIC 90R4), 0.0166 g/L of benzylidene acetone as the grain refiner, 0.1 g/L of methacrylic acid as a secondary grain refiner, 1.5 g/L of alcohol solvent, and 1 g/L of a commercial antioxidant. The pH of the composition was < 1.

Wafer segments (4 cm x 4 cm) with photoresist patterned vias of 75 μm (diameter) x 50 μm (depth) and preformed copper pillars of 37 μm height were immersed in a plating cell containing the above composition and plated with a pure tin layer at a current density of 8 $A/dm^2$. The temperature of the bath was at 25° C. An insoluble platinized titanium electrode was used as the anode, and the wafer segment was the cathode. Electroplating was done until a mushroom shaped tin cap of 23 μm height was plated on top of copper pillars. Morphology of the resulting tin layer was inspected with a Hitachi S2460™ scanning electron microscope, and was found to be uniform, smooth, compact, and free of nodules.

Example 4 (not according to the invention):

Various tin-alloy electroplating compositions are prepared by repeating the procedure of Example 1 and replacing the source of silver ions with the sources of metal ions listed in Table 1.

Table 1

| Sample | Alloy | Source of Alloying Metal Ions |
|---|---|---|
| 4-1 | Sn-Bi | Bismuth methansulfonate (10 g/L Bi) |
| 4-2 | Sn-Cu | Copper methanesulfonate (0.3 g/L Cu) |
| 4-3 | Sn-Ag-Cu | Silver methanesulfonate (0.6 g/L Ag)<br>Copper methanesulfonate (0.2 g/L Cu) |
| 4-4 | Sn-In | Indium methanesulfonate (50 g/L In) |

Example 5 (not according to the invention):

Various electroplating compositions are prepared by repeating the procedure of Example 1 or Example 4 and replacing the nonionic surfactant and the grain refiner with those listed in Table 2. The nonionic surfactant is either formula 3 or 4, where A = EO and B = PO.

Table 2

| Sample | Grain Refiner | Nonionic Surfactant | EO:PO | Average Mol. Wt |
|---|---|---|---|---|
| 6-1 | Cinnamaldehyde (0.022 g/L) | Formula 4 (6 g/L) | 10:90 | 3600 |
| 6-2 | Cinnamaldehyde (0.008 g/L) | Formula 3 (5.5 g/L) | 40:60 | 7240 |
| 6-3 | Benzylidene Acetone (0.013 g/L) | Formula 4 (4.5 g/L) | 70:30 | 15000 |
| 6-4 | Picolinic Acid (0.015 g/L) | Formula 4 (5 g/L) | 40:60 | 6700 |
| 6-5 | Pyridinycarboxaldehyde (0.005 g/L) | Formula 4 (3.5 g/L) | 40:60 | 3400 |
| 6-6 | Benzylidene Acetone (0.022 g/L) | Formula 3 (5 g/L) | 20:80 | 3400 |
| 6-7 | Cinnamic acid (0.025 g/L) | Formula 3 (5.1 g/L) | 20:80 | 5900 |
| 6-8 | Pyridinedicarboxylic acid (0.0075 g/L) | Formula 4 (4.8 g/L) | 40:60 | 5500 |
| 6-9 | Benzylidene Acetone (0.005 g/L) | Formula 4 (4.5 g/L) | 10:90 | 5300 |
| 6-10 | Benzylidene Acetone (0.007 g/L) | Formula 3 (5.5 g/L) | 40:60 | 1650 |

Comparative Example 1: An electroplating composition for depositing a tin-silver alloy was prepared by combining 75 g/L tin (from tin methanesulfonate), 0.5 g/L silver (from silver methanesulfonate), 140 g/L methanesulfuonic acid, 5 g/L of a polyethyleneglycol alpha-(octyl) omega-(3-sulfopropyl)diether, potassium salt as an anionic surfactant (RALUFON EA 15-90, available from Raschig GmbH), 0.0166 g/L of benzylidene acetone as the grain refiner, 2.3 g/L of a dithiaalkyldiol as a silver complexing agent, 1.5 g/L of alcohol solvent, 1 g/L of a commercial antioxidant, and DI water (balance). The pH of the composition was < 1. This composition did not contain a nonionic surfactant as required for the invention. Wafer segments (4 cm x 4 cm) with photoresist patterned vias of 75 μm (diameter) x 75 μm (depth) and a copper seed layer were immersed in the electroplating composition and plated with tin-silver bumps according to the procedure of Example 1. The resulting tin-silver solder bump deposits too rough for WID uniformity measurements. Fig. 2 is a SEM of a tin-silver solder deposit as plated using the electroplating composition.

Comparative Example 2: An electroplating composition for depositing a tin-silver alloy was prepared by combining 75 g/L tin (from tin methanesulfonate), 0.5 g/L silver (from silver methanesulfonate), 140 g/L methanesulfuonic acid, 5 g/L of a tetrafunctional block copolymer derived from the sequential addition of PO and EO to ethylenediamine nonionic surfactant (EO:PO of approximately 10:90, TETRONIC 701), 0.05 g/L of 2',3,4',5,7-pentahydroxyflavone as the grain refiner, and 2.3 g/L of a dithiaalkyldiol as a silver complexing agent. The pH of the composition was < 1. This composition did not contain a grain refiner as required for the invention. Wafer segments (4 cm x 4 cm) with photoresist patterned vias of 75 μm (diameter) x 75 μm (depth) and a copper seed layer were immersed in the electroplating composition and plated with tin-silver bumps according to the procedure of Example 1. The resulting tin-silver solder bump deposit showed poor WID uniformity (11%).

Comparative Example 3: An electroplating composition for depositing a tin-silver alloy was prepared by combining 75 g/L tin (from tin methanesulfonate), 0.65 g/L silver (from silver methanesulfonate), 104 g/L methanesulfuonic acid, 5 g/L of a tetrafunctional block copolymer derived from the sequential addition of EO and PO to ethylenediamine nonionic surfactant (EO:PO of approximately 40:60, TETRONIC 90R4), 0.6 g/L of a dithiaalkyldiol as a first silver complexing agent, 3.1 g/L of a mercaptotetrazole derivative as a second silver complexing agent, 1.5 g/L of alcohol solvent, 1 g/L of a commercial antioxidant, and DI water (balance). The pH of the composition was < 1. This composition did not contain a grain refiner. Wafer segments (4 cm x 4 cm) with photoresist patterned vias of 75 μm (diameter) x 75 μm (depth) and a copper seed layer were immersed in the electroplating composition and plated with tin-silver bumps according to the procedure of Example 1. The resulting tin-silver solder bump deposit showed poor WID uniformity (12%).

## Claims

**1.** A method of electroplating a tin-containing layer comprising:

providing a semiconductor wafer comprising a plurality of conductive bonding features, wherein the conductive bonding features are copper pillars;
contacting the semiconductor wafer with an electroplating composition comprising:

a source of tin ions; an acid electrolyte; 0.0001 to 0.045 g/L of a grain refiner of formula (1)

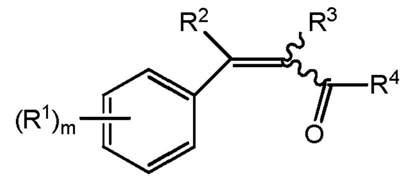

(1)

wherein each $R^1$ is independently $(C_{1}\text{-}_{6})$alkyl, $(C_{1}\text{-}_{6})$alkoxy, hydroxy, or halo; $R^2$ and $R^3$ are independently chosen from Hand $(C_{1}\text{-}_{6})$alkyl; $R^4$ is H, OH, $(C_{1}\text{-}_{6})$alkyl or $O(C_{1}\text{-}_{6})$alkyl; m is an integer from 0 to 2; one or more nonionic surfactants of formula (3) or (4):

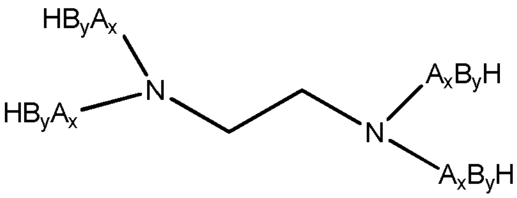

(3)

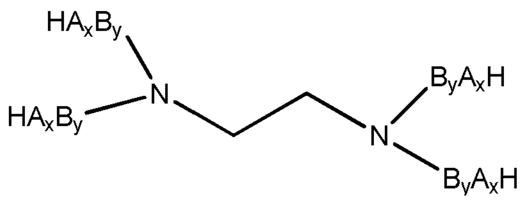

(4)

wherein A and B represent different alkyleneoxide moieties independently chosen from $(C_{2\text{-}4})$alkyleneoxides, and x and y represent the number of repeat units of each alkyleneoxide, respectively; and water; and applying sufficient current density to deposit a tin-containing layer on the conductive bonding features; wherein the electroplating composition has a within-die uniformity of ≤ 5% and wherein the tin-containing layer on the conductive bonding features is substantially free of voids as plated and after reflow;
wherein the within-die uniformity is tested by patterned wafers having 75 μm diameter vias, 3 different pitch sizes which are 150, 225 and 375 μm, a platable area of 3-20%, a negative dry film resist height of 75 μm, and a seed of 1 kÅ Ti / 3 kÅ Cu, and measuring the height of 11 tin-containing bumps on each die using a stylus profilometer to obtain within-die uniformity calculated by equation 1 below in which within-die uniformity is expressed as "coplanarity":

$$Coplanarity(\%) = \frac{h_{max} - h_{min}}{2h_{avg}} \times 100 \quad (1)$$

where $h_{max}$ is the height of the highest tin-containing bump in a die, $h_{min}$ is the height of the shortest tin-containing bump in a die, and $h_{avg}$ is the average height of tin-containing solder bumps.

2. The method of claim 1 wherein the grain refiner is a mixture of 2 different grain refiners of formula (1) where $R^1$, $R^2$, $R^3$, $R^4$ and m are as defined in claim 1.

3. The method of claim 1 or 2 wherein the grain refiner is present in an amount of 0.0001 to 0.04 g/L.

4. The method of any preceding claim wherein the tin-containing layer is a pure tin layer or a tin-alloy layer.

5. The method of claim 4 wherein the tin-alloy layer is chosen from tin-silver, tin-silver-copper, tin-silver-copper-antimony, tin-silver-copper-manganese, tin-silver-bismuth, tin-silver-indium, tin-silver-zinc-copper, and tin-silver-indium-bismuth.

**6.** The method of any preceding claim wherein the mole ratio of x:y is from 10:90 to 90: 10.

**7.** The method of any preceding claim wherein the grain refiner is chosen from cinnamic acid, cinnamaldehyde, benzylidene acetone, and mixtures thereof.

**8.** The method of any preceding claim wherein the electroplating composition further comprises a secondary grain refiner chosen from (meth)acrylic acid, crotonic acid, $(C_{1-6})$alkyl (meth)acrylate, (meth)acrylamide, $(C_1\text{-}C_6)$alkyl crotonate, crotonamide, crotonaldehyde, (meth)acrylaldehyde, and mixtures thereof.

**9.** The method of claim 8 wherein the secondary grain refiner is present in an amount of 0.005 to 0.5 g/L.

**10.** The method of any preceding claim wherein the tin-containing layer as plated has a mean surface roughness (Ra) of ≤ 200 nm, as measured using an optical profilometer.

**11.** The method of any one of claims 1-6 and 8-10 wherein $R^4$ is $(C_{1-6})$alkyl.

**Patentansprüche**

**1.** Verfahren zur elektrolytischen Abscheidung einer zinnhaltigen Schicht, umfassend:

Bereitstellen eines Halbleiterwafers, umfassend eine Vielzahl von leitenden Bondingmerkmalen, wobei die leitenden Bondingmerkmale Kupfersäulen sind;
Inkontaktbringen des Halbleiterwafers mit einer Zusammensetzung zur elektrolytischen Abscheidung, umfassend:

eine Zinnionenquelle; einen sauren Elektrolyten; 0,0001 bis 0,045 g/l eines Kornfeinungsmittels der Formel (1)

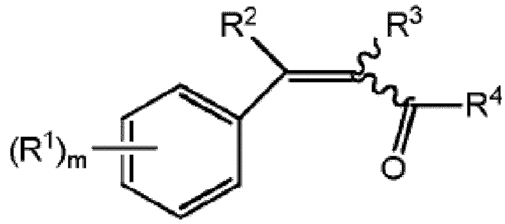

(1)

wobei jedes $R^1$ unabhängig $(C_{1-6})$-Alkyl, $(C_{1-6})$-Alkoxy, Hydroxy oder Halogen ist; $R^2$ und $R^3$ unabhängig aus H und $(C_{1-6})$-Alkyl ausgewählt sind; $R^4$ H, OH, $(C_{1-6})$-Alkyl oder $O(C_{1-6})$-Alkyl ist; m eine ganze Zahl von 0 bis 2 ist; ein oder mehrere nichtionische Tenside der Formel (3)oder (4):

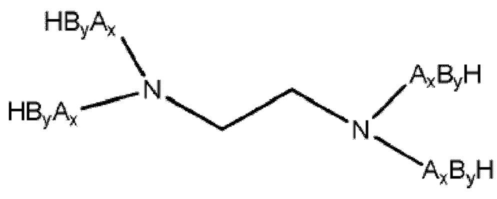

(3)

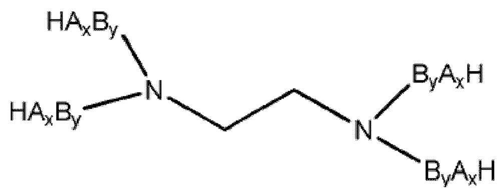

(4)

wobei A und B verschiedene Alkylenoxid-Einheiten darstellen, die unabhängig aus $(C_{2-4})$-Alkylenoxiden ausgewählt sind, und x und y die Anzahl von sich wiederholenden Einheiten jedes Alkylenoxids darstellen; und Wasser; und
Anlegen einer ausreichenden Stromdichte, um eine zinnhaltige Schicht auf den leitenden Bondingmerkmalen abzuscheiden;
wobei die Zusammensetzung zur elektrolytischen Abscheidung eine Gleichförmigkeit innerhalb der Matrize

von ≤ 5 % aufweist und wobei die zinnhaltige Schicht auf den leitenden Bondingmerkmalen, als abgeschieden und nach dem Aufschmelzen, im Wesentlichen frei von Hohlräumen ist;
wobei die Gleichförmigkeit innerhalb der Matrize durch strukturierte Wafer mit Durchgangskontaktierungen mit einem Durchmesser von 75 μm, 3 verschiedenen Pitch-Größen, nämlich 150, 225 und 375 μm, einer abscheidungsfähigen Fläche von 3 bis 20 %, einer negativen Trockenfilmresisthöhe von 75 μm und einem Seed von 1 kÅ Ti / 3 kÅ Cu getestet wird und Messen der Höhe von 11 zinnhaltigen Bumps auf jeder Matrize unter Verwendung eines Stylus-Profilometers, um eine Gleichförmigkeit innerhalb der Matrize zu erhalten, die durch die nachstehende Gleichung 1 berechnet wird, in der die Gleichförmigkeit innerhalb der Matrize als "Koplanarität" ausgedrückt ist:

$$\text{Koplanarität (\%)} = \frac{h_{max} - h_{min}}{2h_{avg}} \times 100$$

wobei $h_{max}$ die Höhe des höchsten zinnhaltigen Bumps auf einer Matrize ist, $h_{min}$ die Höhe des kürzesten zinnhaltigen Bumps in einer Matrize ist und $h_{avg}$ die durchschnittliche Höhe der zinnhaltigen Lötbumps ist.

2. Verfahren nach Anspruch 1, wobei das Kornfeinungsmittel ein Gemisch aus zwei verschiedenen Kornfeinungsmitteln der Formel (1) ist, wobei $R^1$, $R^2$, $R^3$, $R^4$ und m wie in Anspruch 1 definiert sind.

3. Verfahren nach Anspruch 1 oder 2, wobei das Kornfeinungsmittel in einer Menge von 0,0001 bis 0,04 g/l vorliegt.

4. Verfahren nach einem vorhergehenden Anspruch, wobei die zinnhaltige Schicht eine Schicht von reinem Zinn oder eine Zinnlegierungsschicht ist.

5. Verfahren nach Anspruch 4, wobei die Zinn-Legierungsschicht aus Zinn-Silber, Zinn-Silber-Kupfer, Zinn-Silber-Kupfer-Antimon, Zinn-Silber-Kupfer-Mangan, Zinn-Silber-Wismut, Zinn-Silber-Indium, Zinn-Silber-Zink-Kupfer und Zinn-Silber-Indium-Wismut ausgewählt ist.

6. Verfahren nach einem vorhergehenden Anspruch, wobei das Molverhältnis von x:y 10:90 bis 90:10 ist.

7. Verfahren nach einem vorhergehenden Anspruch, wobei das Kornfeinungsmittel aus Zimtsäure, Zimtaldehyd, Benzylidenaceton und Gemischen davon ausgewählt ist.

8. Verfahren nach einem vorhergehenden Anspruch, wobei die Zusammensetzung zur elektrolytischen Abscheidung ferner ein sekundäres Kornfeinungsmittel umfasst, ausgewählt aus (Meth)acrylsäure, Crotonsäure, $(C_{1-6})$-Alkyl(meth)acrylat, (Meth)acrylamid, $(C_1\text{-}C_6)$-Alkylcrotonat, Crotonamid, Crotonaldehyd, (Meth)acrylaldehyd und Gemischen davon.

9. Verfahren nach Anspruch 8, wobei das sekundäre Kornfeinungsmittel in einer Menge von 0,005 bis 0,5 g/l vorliegt.

10. Verfahren nach einem vorhergehenden Anspruch, wobei die wie abgeschieden zinnhaltige Schicht eine mittlere Oberflächenrauhigkeit (Ra) von ≤ 200 nm aufweist, wie gemessen unter Verwendung eines optischen Profilometers.

11. Verfahren nach einem der Ansprüche 1 bis 6 und 8 bis 10, wobei $R^4$ $(C_{1-6})$-Alkyl ist.

**Revendications**

1. Méthode pour l’électrodéposition d’une couche contenant de l’étain comprenant :

la fourniture d’une tranche semi-conductrice comprenant une pluralité de caractéristiques de liaison conductrices, où les caractéristiques de liaison conductrices sont des piliers en cuivre ;
la mise en contact de la tranche semi-conductrice avec une composition d’électrodéposition comprenant :

une source d’ions étain ; un électrolyte acide ; de 0,0001 à 0,045 g/L d’un raffineur de grain de formule (1)

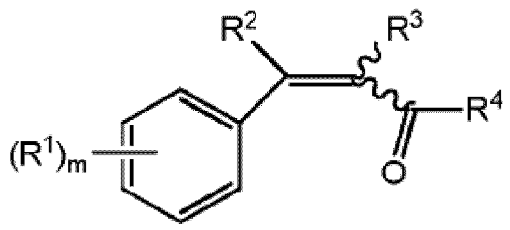

(1)

dans laquelle chaque $R^1$ est indépendamment un alkyle en $C_{1-6}$, un alkoxy en $C_{1-6}$, hydroxy ou halo ; $R^2$ et $R^3$ sont indépendamment choisis parmi H et un alkyle en $C_{1-6}$ ; $R^4$ est H, OH, un alkyle en $C_{1-6}$ ou un O-alkyle en $C_{1-6}$ ; m est un nombre entier de 0 à 2 ; un ou plusieurs agents tensioactifs non ioniques de formule (3) ou (4) :

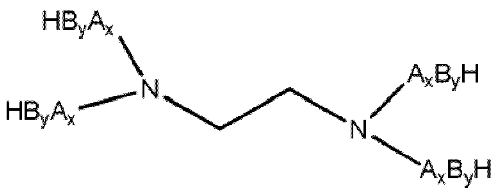

(3)

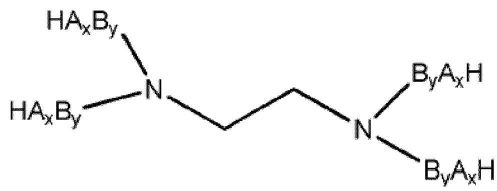

(4)

dans lesquelles A et B représentent différentes fractions oxyde d'alkylène indépendamment choisies parmi les oxydes d'alkylène en $C_{2-4}$, et x et y représentent le nombre d'unités répétées de chaque oxyde d'alkylène, respectivement ; et l'eau ; et
l'application d'une densité de courant suffisante pour déposer une couche contenant de l'étain sur les caractéristiques de liaison conductrices ;
dans laquelle la composition d'électrodéposition a une uniformité à l'intérieur de la matrice ≤ 5 % et dans laquelle la couche contenant de l'étain sur les caractéristiques de liaison conductrices est sensiblement dépourvue de vides telle qu'électrodéposée et après reflux ;
dans laquelle l'uniformité à l'intérieur de la matrice est testée par des tranches à motifs ayant des trous d'interconnexion de 75 μm de diamètre, 3 tailles de pas différentes qui sont de 150, 225 et 375 μm, une zone électrodéposable de 3 à 20 %, une hauteur de réserve de film sec négative de 75 μm, et une amorce de 1 kÅ Ti / 3 kÅ Cu, et mesurant la hauteur de 11 bosses contenant de l'étain sur chaque matrice à l'aide d'un profilomètre à stylet pour obtenir une uniformité à l'intérieur de la matrice calculée par l'équation 1 ci-dessous dans laquelle l'uniformité à l'intérieur de la matrice est exprimée en tant que « coplanarité » :

$$\text{Coplanarité (en \%)} = \; = \frac{h_{\max} - h_{\min}}{2h_{avg}} \times 100$$

où $h_{max}$ est la hauteur de la bosse contenant de l'étain la plus haute dans une matrice, $h_{min}$ est la hauteur de la bosse contenant de l'étain la plus basse dans une matrice, et $h_{avg}$ est la hauteur moyenne des bosses de soudure contenant de l'étain.

2. Méthode selon la revendication 1 dans laquelle le raffineur de grain est un mélange de 2 raffineurs de grain différents de formule (1) dans laquelle $R^1$, $R^2$, $R^3$, $R^4$ et m sont tels que définis dans la revendication 1.

3. Méthode selon la revendication 1 ou 2 dans laquelle le raffineur de grain est présent en une quantité de 0,0001 à 0,04 g/L.

4. Méthode selon l'une quelconque des revendications précédentes dans laquelle la couche contenant de l'étain est une couche d'étain pur ou une couche d'alliage d'étain.

5. Méthode selon la revendication 4 dans laquelle la couche d'alliage d'étain est choisie parmi étain-argent, étain-argent-cuivre, étain-argent-cuivre-antimoine, étain-argent-cuivre-manganèse, étain-argent-bismuth, étain-argent-indium, étain-argent-zinc-cuivre et étain-argent-indium-bismuth.

**6.** Méthode selon l'une quelconque des revendications précédentes dans laquelle le rapport molaire de x:y est de 10:90 à 90:10.

**7.** Méthode selon l'une quelconque des revendications précédentes dans laquelle le raffineur de grain est choisi parmi l'acide cinnamique, le cinnamaldéhyde, la benzylidène acétone et des mélanges de ceux-ci.

**8.** Méthode selon l'une quelconque des revendications précédentes dans laquelle la composition d'électrodéposition comprend en outre un raffineur de grain secondaire choisi parmi l'acide (méth)acrylique, l'acide crotonique, le (méth)acrylate d'alkyle en $C_1$-$_6$, le (méth)acrylamide, le crotonate d'alkyle en $C_1$-$C_6$, le crotonamide, le crotonaldéhyde, le (méth)acrylaldéhyde et des mélanges de ceux-ci.

**9.** Méthode selon la revendication 8 dans laquelle le raffineur de grain secondaire est présent en une quantité de 0,005 à 0,5 g/L.

**10.** Méthode selon l'une quelconque des revendications précédentes dans laquelle la couche contenant de l'étain telle qu'électrodéposée a une rugosité de surface moyenne (Ra) ≤200 nm, telle que mesurée à l'aide d'un profilomètre optique.

**11.** Méthode selon l'une quelconque des revendications 1 à 6 et 8 à 10 dans laquelle $R^4$ est un alkyle en $C_{1-6}$.

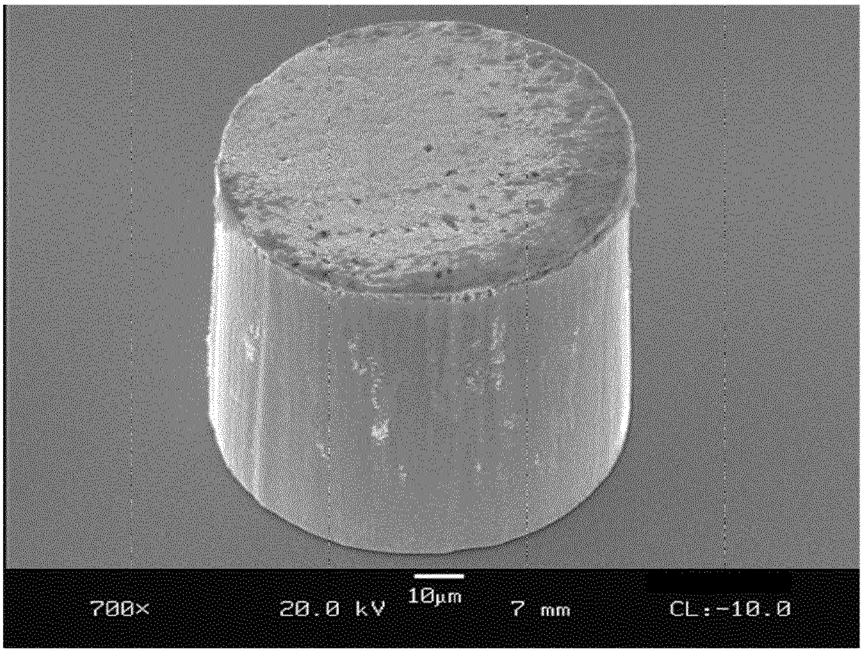


*Fig. 1*

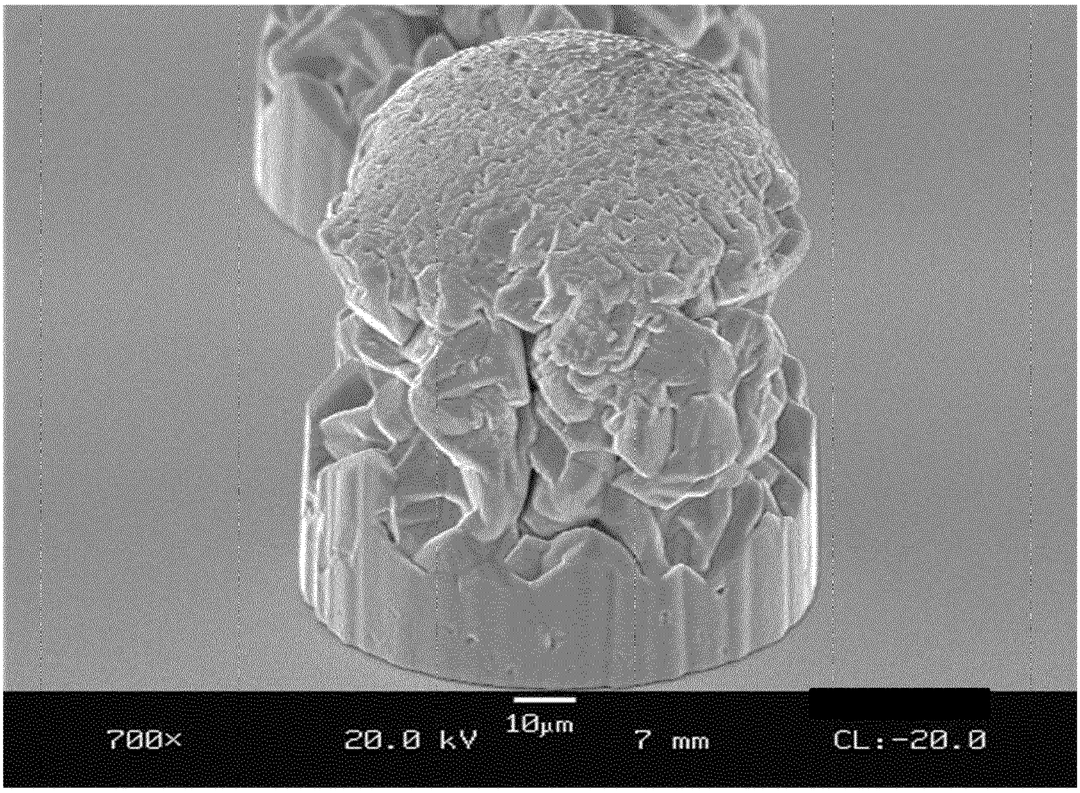


*Fig. 2*

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description

- US 7314543 B
- JP 2856857 B
- EP 2626449 A2
- US 4871429 A
- US 4582576 A
- US 5174887 A
- US 7781325 B
- US 20080054459 A
- US 20080296761 A
- US 20060094226 A